# EUROPEAN PATENT APPLICATION

(11) **EP 0 680 249 A2**
(43) Date of publication of application: **02.11.1995**
(21) Application number: 95302580.6
(22) Date of filing: 19.04.1995
(51) Int. Cl.: H05K 7/20, H01L 23/367, H01L 23/40

(54) **Fabricated sheet metal heat sink**

(30) Priority: 29.04.1994 US 235574
(71) Applicant: AT&T Corp., New York, NY 10013-2412 (US)
(72) Inventor: Kam, Lit-Yan, Wayside, New Jersey 07712 (US)
(74) Representative: Johnston, Kenneth Graham

(57) **Abstract**

A novel method and apparatus utilizing sheet metal fabricated to form highly effective heat sinks having a low cost is disclosed. Fabrication techniques including punching and bending are used to create one or more tubes having substantially rectangular cross-sections. The rectangular-section tubes share a common base. In a particular illustrative example of the invention, a plurality of substantially rectangular-section tubes are arranged so that the sheet metal heat sink may interface with a circuit pack having a plurality of heat-producing and other components.

## Description

### Technical Field

This invention relates to the cooling of heat-producing components. More particularly, this invention relates to sheet metal heat sinks used to cool circuit pack assemblies and the like.

### Background

Effectively dissipating the heat produced by the operation of electronic components, such as integrated circuit ("IC") packages, is an important concern in optimizing the performance of the circuitry in which those components are used. In addition to optimizing performance, effective heat dissipation also helps to prolong the useful life of those components and enhances both component and system reliability. Effective heat dissipation is of particular concern in circuit pack assemblies comprising several IC packages mounted on a common substrate because heat is a major cause of failure of such circuit packs assemblies.

To dissipate heat, an IC package is typically provided with a heat sink made of metal with high thermal conductivity to add additional surface area for cooling to the IC package. Such heats sinks often utilize an array of elongated fins arranged on a common platform where the platform is bonded or otherwise mechanically attached to the top of the IC package. Cooling fluid, such as air, circulates through the fins to conduct heat away from the IC package by means of forced or natural convection.

Typically, a single heat sink is used to cool several IC packages in a circuit pack in order to simplify assembly and to optimize space utilization in the circuit pack. The circuit pack usually has a number of electrical and mechanical components mounted in close proximity to the IC packages. The heat sink must not obstruct or interfere with such components in most applications. Thus, it may be required that a heat sink have a complex shape in order to effectively interface with a particular circuit pack. The complexity will depend upon the number and location of the IC packages and other components in the circuit pack.

A popular material for heat sinks is aluminum because of its light weight, good thermal conductivity, and low cost. Additionally, aluminum may be readily shaped using conventional extrusion processes and machining operations. For low production volumes, heat sinks are often formed from a block of aluminum using a series of machining operations which results in a high unit cost. For higher production volumes, an extrusion process may be used to realize some cost savings. However, the required extrusion die may represent a significant cost in some applications. Moreover, secondary machining is usually required to form the extrusion into its final shape, which if complex, may make the finished heat sink prohibitively expensive.

### Summary

The need for adequate cooling of heat-producing components is satisfied, in accordance with the invention, by a novel method and apparatus utilizing a single fabricated sheet of metal to provide highly effective, yet low cost, heat sinks. Fabrication techniques including punching and bending are used to create one or more tubes having substantially rectangular cross-sections. The rectangular-section tubes share a common base. In a particular illustrative example of the invention, a plurality of substantially rectangular-section tubes are arranged so that the sheet metal heat sink may interface with a circuit pack having a plurality of heat-producing and other components.

The discussion in this Summary and the following Brief Description of the Drawings, Detailed Description, and drawings only deals with examples of this invention and is not to be considered in any way a limitation on the scope of the exclusionary rights conferred by a patent which may issue from this application. The scope of such exclusionary rights is set forth in the claims at the end of this application.

### Brief Description of the Drawings

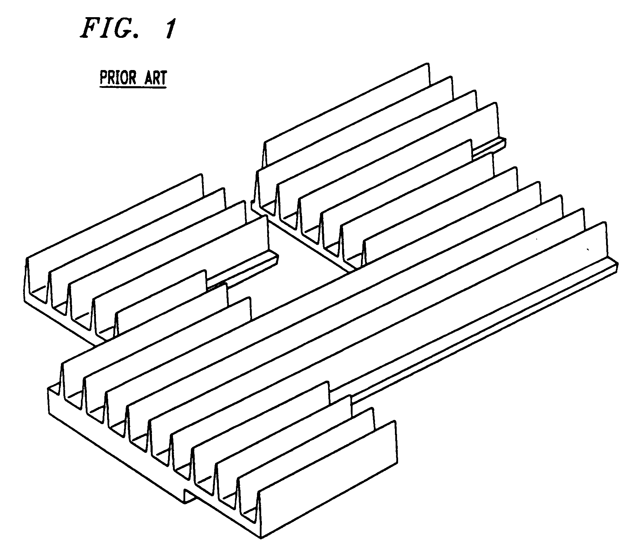

FIG. 1 is a pictorial view of a conventional extruded and machined metal heat sink.

FIG. 2 is a pictorial view of an illustrative circuit pack.

FIG. 3 is a pictorial view of an illustrative fabricated sheet metal heat sink, in accordance with the invention.

FIG. 4 is a pictorial view of the illustrative fabricated sheet metal heat sink shown in FIG. 3 in combination with the circuit pack shown in FIG. 2.

FIG. 5 is a planar view of the heat sink shown in FIG. 3 at an intermediate stage of its fabrication.

FIGs. 6, 7, and 8 are pictorial views of the heat sink shown in FIG. 3 at various stages of fabrication.

FIG. 9 is a planar view of a second illustrative example of a heat sink, in accordance with the invention, at an intermediate stage of its fabrication.

FIG. 10 is a pictorial view of a second illustrative heat sink, in accordance with the invention.

FIG. 11 shows a front view of an aspect of the invention.

FIG. 12 is a exploded pictorial view of the aspect of the invention shown in FIG. 11.

### Detailed Description

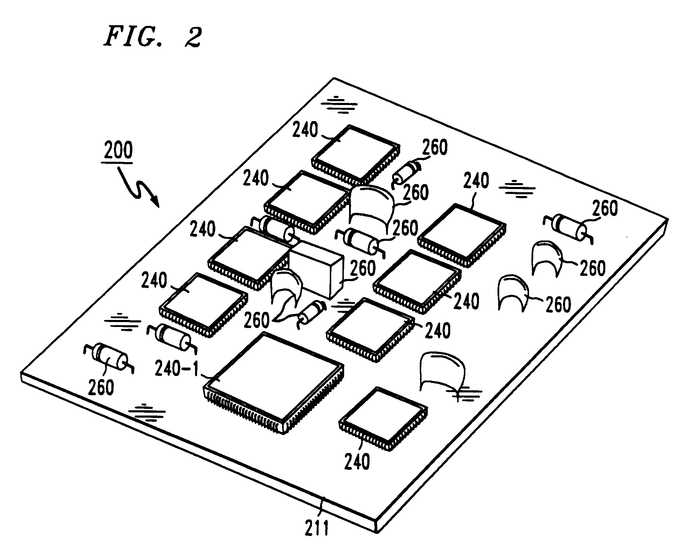

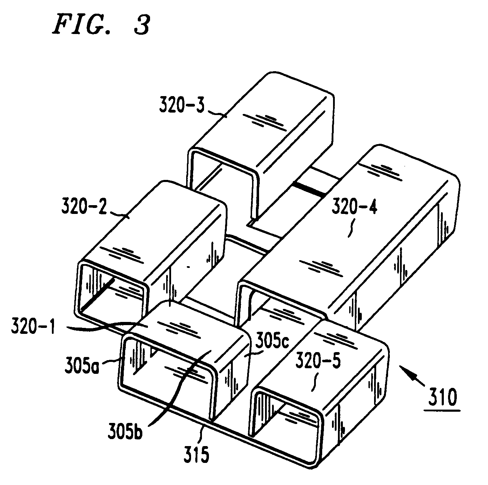

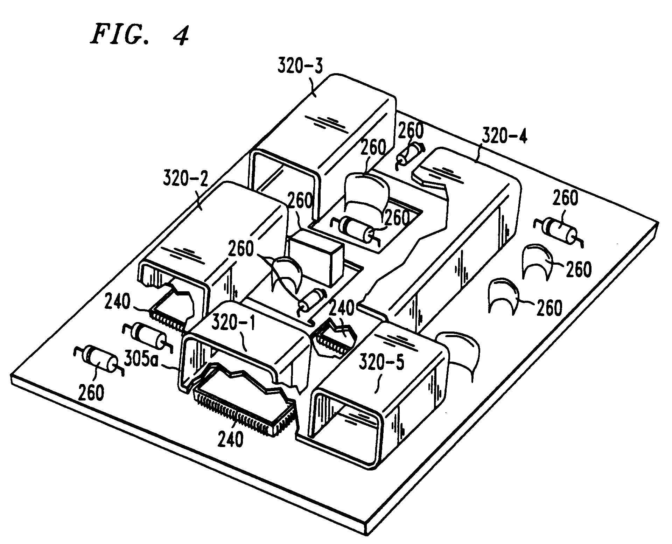

Referring to FIGs. 2 through 4, an illustrative example of the invention is described in detail. FIG. 2 is a pictorial view of a circuit pack having a plurality of heat-producing components for which cooling is desired. FIG.3 is a pictorial view of an illustrative fabricated sheet metal heat sink 310, in accordance with the invention. FIG. 4 shows heat sink 310 attached to the circuit pack shown in FIG. 2. As shown in FIG.3, heat sink 310 comprises a a single sheet of metal formed into plurality of tubes each substantially rectangular in cross section. These rectangular-section tubes are identified by reference numerals 320-1 through 320-5. Rectangular-section tubes 320 are positioned to give heat sink 310 a shape that is particularly adapted to interface with the illustrative circuit pack 200 shown in FIG. 2. Those skilled in the art will appreciate that the particular number and position of rectangular-section tubes 320 will depend on the arrangement of heat-producing components in circuit pack 200 (FIG. 2) to which heat sink 310 is attached. Therefore, the number of rectangular-section tubes 320 may be other than five, and the position of the rectangular-section tubes may be other than shown, without departing from the spirit and nature of the invention.

For purposes of clarity in illustration, reference numeral 305 is used to identify the walls of rectangular-section tube 320-1. However, those skilled in the art will appreciate that the following discussion is equally applicable to all rectangular-section tubes 320. Rectangular-section tube 320-1 in heat sink 310 has three heat-dissipating walls 305a, 305b, and 305c. The fourth wall of rectangular-section tube 320-1 is base 315. As shown in FIG.3, base 315 is forms the fourth wall of all rectangular-section tubes 320 and is thus common to each. Heat-dissipating wall 305a extends upward from, and is substantially perpendicular to base 315. Heat-dissipating wall 305b extends laterally from, and is substantially perpendicular to heat-dissipating wall 305a. Heat-dissipating wall 305c extends downward from, and is substantially perpendicular to heat-dissipating wall 305b. In this illustrative example, heat-dissipating wall 305c extends downward so that its edge nearly contacts base 315. Thus, in this illustrative example, heat-dissipating wall 305c is not directly attached to base 315. In some applications, however, it may be desirable that heat-dissipating wall 305c be directly attached to base 315, which may be accomplished using any conventional technique, for example, by welding. Such direct attachment may be advantageous in some applications because the heat produced by an IC package can then be directly dissipated by heat dissipating wall 305c rather than indirectly dissipated after first passing through heat dissipating walls 305a and 305b.

Heat sink 310 may be constructed of any material having good thermal conductivity characteristics such as aluminum and its alloys, for example, 1100 H18 aluminum which has a thermal conductivity *k* of 1540 Btu-in/hr-ft²-°F. FIG.3 also shows that heat sink 310 has two openings in its base 315: one opening is substantially rectangular and is positioned between rectangular-section tubes 320-3 and 320-4; the other opening has a reverse "L" shape and is positioned between rectangular-section tubes 320-2 and 320-4.

FIG. 2 is a pictorial view of an illustrative circuit pack for which the illustrative heat sink 310 shown in FIG. 3 is particularly adapted. Circuit pack 200 is representative of those typically used in the electronic arts. Circuit pack 200 comprises a substrate 211, such as a circuit board, to which are mounted a plurality of integrated circuit ("IC") packages 240. IC packages 240 contain heat-producing electronic chips (not shown) that must be cooled by an external heat sink to ensure that the chips do not overheat. In this illustrative example, the top surfaces of IC packages 240 are substantially co-planar. Circuit pack 200 also includes other electrical components, such as capacitors and resistors and the like, and mechanical elements such as posts and brackets. These other components are identified by reference numeral 260. Components 260, as will be appreciated by those skilled in the art, may have various geometrical configurations, and may be positioned at various locations on substrate 211.

FIG. 4 is a pictorial view of the illustrative sheet metal heat sink 310 in combination with circuit pack 200. Heat sink 310 is positioned in relation to circuit pack 200 so that the bottom surface of base 315 is in heat conductive contact with the top surface of each of IC packages 240. Thermal joint compound (i.e., heat conductive grease) may be used in the interface between heat sink 310 and IC packages 240 to further enhance the heat conductive contact. Heat sink 310 may be attached to IC packages 240 and/or substrate 211 using any conventional technique, for example, via mechanical fasteners, solder, adhesives and the like. As shown in FIG. 4, each IC package in circuit pack 200 is located immediately below a rectangular-section tube 320 in heat sink 310 to advantageously allow the large surface area of the rectangular-section tube to efficiently dissipate the heat produced by the chip contained in the IC package. The openings in base 315 are located so as to prevent interference between heat sink 310 and other components 260 in circuit pack 200 by allowing a pass-through for components 260. Those skilled in the art will appreciate that rectangular-section tubes 320 are positioned not only to be immediately above IC packages 240 for heat dissipation purposes as described above, but are also positioned relative to circuit pack 200 to avoid interference with those components 260 which are in proximity to IC packages 240 around the periphery of circuit pack 200.

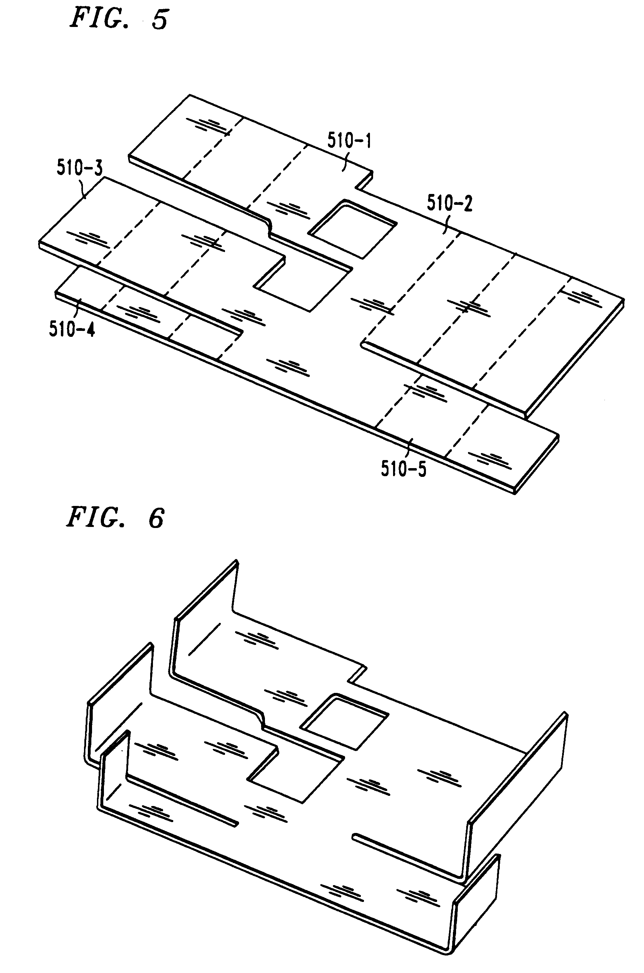

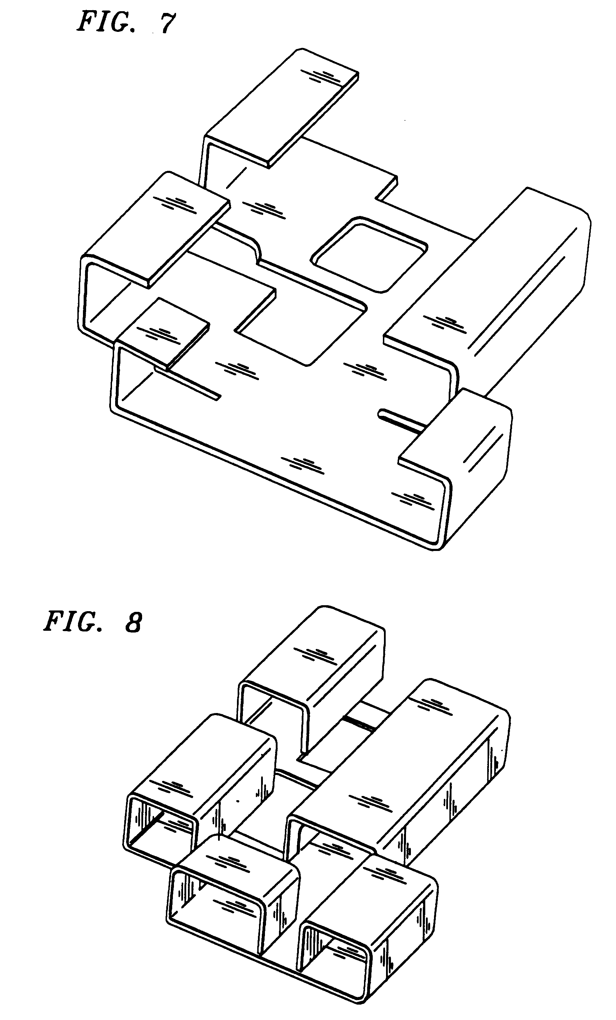

Referring now to FIGs. 5 through 8, the method of fabrication of the illustrative heat sink 310 (FIG. 3) is shown. FIG. 5 is a planar view of heat sink 310 at an intermediate stage of its fabrication. FIGs. 6, 7, and 8 are pictorial views of heat sink 310 at various stages of fabrication. Heat sink 310 may be fabricated from single flat sheet of metal which may be, typically, rectangular in shape. Such a flat sheet is known as a "blank." The rectangular blank is punched, using an appropriate tool, to create one or more individual heat dissipating portions of the blank which are formed into rectangular-section tubes 320, and the aforementioned openings in base 315. FIG. 5 shows the blank after this punching step for this illustrative example. The individual heat dissipating portions are identified by reference numerals 510-1 to 510-5. Alternatively, the blank may be formed to conform with FIG. 5 by other conventional fabrication techniques, or combinations thereof, such as cutting, sawing, or shearing and the like.

After the punching step, the individual heat dissipating portions of the blank 510-1 to 510-5 are formed into rectangular-section tubes 320 (FIG. 3). Accordingly, each individual heat dissipating portion undergoes a succession of three 90 degree bends along appropriately located imaginary bend lines. The imaginary bend lines in this illustrative example are shown in FIG. 5 as dashed lines. Preferably, the first bend is made in an individual heat dissipating portion 510 along that bend line which is furthest from the center of the blank. Then, working in towards the center of the blank, the second bend and then the third bend are made to form a substantially rectangular-section tube from an individual heat dissipating portion 510. Those skilled in the art will appreciate that the rectangular-section tubes 320 in this illustrative example could be formed one at a time using the bending process described above. Alternatively, the rectangular-section tubes 320 could be formed simultaneously where all the first bends are performed on all the individual heat dissipating portions 510 before any second bend is performed, and so on, until all the rectangular-section tubes 320 (FIG. 3) are formed. FIGs. 6, 7, and 8 illustrate this alternative fabrication approach.

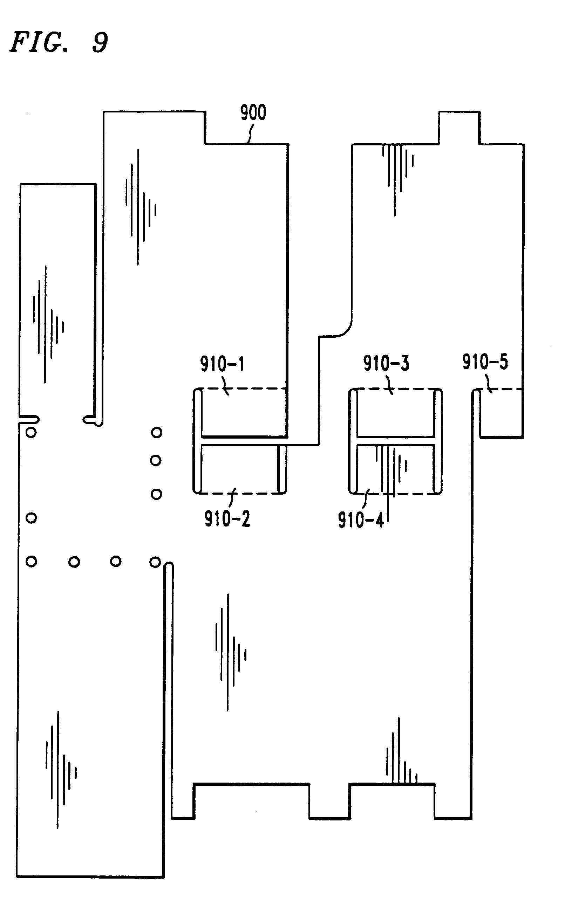

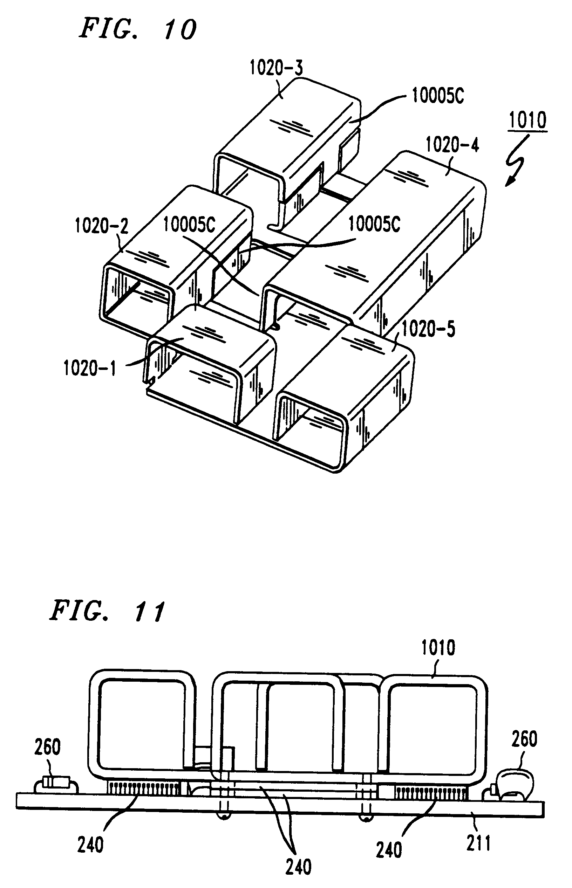

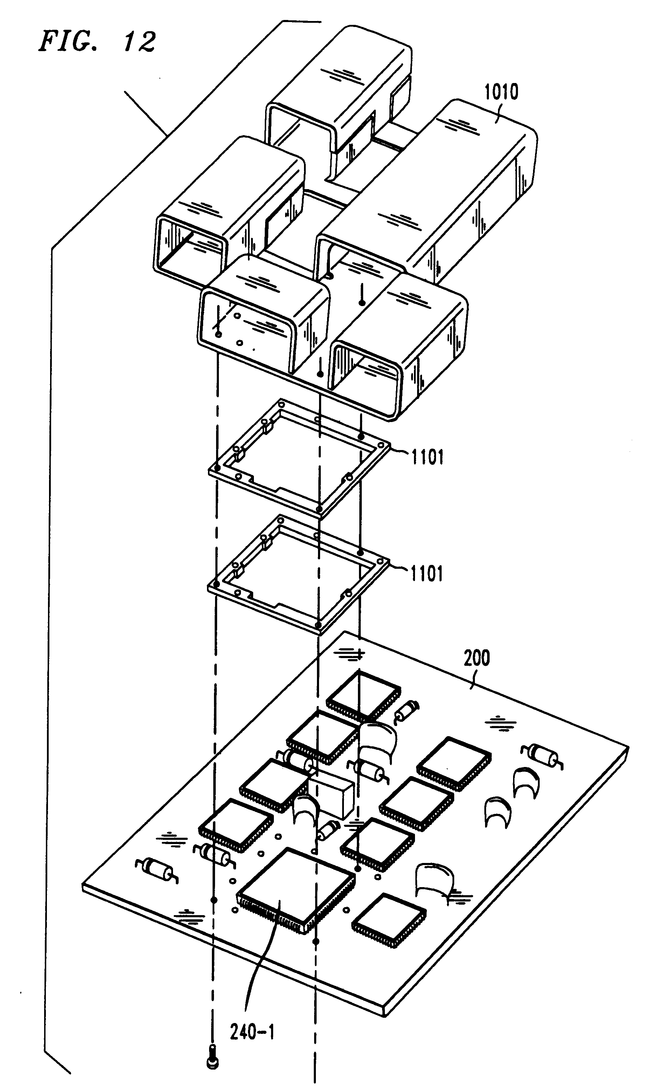

FIG. 9 shows a sheet metal blank 900 after the punching step described above in accordance with another illustrative example of the invention. Blank 900 in this example is similar to the one shown in FIG. 5 with the exception that the openings for component pass-through are not punched out. Also, several holes are included in blank 900 to faciliate the inclusion of an aspect of the invention described when referring to FIGs. 11 and 12. Additional heat dissipating portions 910-1 to 910-5 are provided in blank 900 as shown. These portions, when bent 90 degrees from the base portion of the heat sink, allow openings to be formed while reducing the amount of wasted material in the blank. Corresponding areas from the edges of blank 900 are removed in the punching process to allow walls 1005c of the rectangular-section tubes 1020 to be formed in the illustrative heat sink 1010 as shown in FIG. 10. Rectangular-section tubes 1020 are formed in accordance with the method described above and while referring to FIGs. 5 through 8. In some applications, the utilization of such walls may advantageously allow a reduction in blank size. Those skilled in the art will also appreciate that heat dissipating portions 910 allow more heat sink surface area to be placed in direct proximity to the heat-producing sources, namely IC packages 240.

FIGs. 11 and 12 show another aspect of the invention. FIG. 11 shows, in a front view, several rectangular spacers 1101 that are placed between heat sink 1010 and circuit pack 200. FIG. 12 shows an exploded pictorial view of heat sink 1010, spacers 1101, and circuit pack 200. Spacers 1101 are adapted to fit closely around IC package 240-1 so as to provide a good measure of shielding to IC package 240-1 from electromagnetic interference ("EMI"). Spacers 1101 may be secured between heat sink 1010 and circuit pack 200 using screws, as shown, or any other convenient attaching means such as adhesive or solder. Spacers 1101 are preferably fabricated from sheet metal with good EMI shielding characteristics, such as aluminum, using a conventional technique such as punching.

Various illustrative examples of the invention have been described in detail. In addition, however, many modifications and changes can be made to these examples without departing from the nature and spirit of the invention. For example, it may be desirable in some applications of the invention that some or all of the punching and bending steps could be performed simultaneously depending upon, for example, the complexity of the shape of the heat sink and the degree to which automated production is available or desired.

## Claims

1. A method of making a heat sink, comprising the steps of:
providing a substantially flat sheet of metal where the flat sheet defines a reference plane;
bending a heat dissipative portion of the sheet to create a first substantially planar surface which is substantially perpendicular to the reference plane;
bending the heat dissipative portion to create a second substantially planar surface which is substantially perpendicular to the first substantially planar surface and substantially perpendicular to the reference plane; and
bending the heat dissipative portion to create a third substantially planar surface which is substantially perpendicular to the second substantially planar surface and substantially perpendicular to the reference plane so as to create a substantially rectangular-section tube.

2. An apparatus for use as a heat sink comprising:
a substantially flat sheet of metal where the flat sheet defines a reference plane;
a first heat dissipative portion of the sheet having a substantially planar surface which is substantially perpendicular to the reference plane;
a second heat dissipative portion of the sheet having a substantially planar surface which is substantially perpendicular to the first heat dissipative portion and substantially perpendicular to the reference plane; and
a third heat dissipative portion having a substantially planar surface which is substantially perpendicular to the second heat dissipative portion and substantially perpendicular to the reference plane so as to create a substantially rectangular-section tube.

3. The method of claim 1 or the apparatus of claim 2, in which the sheet includes a plurality of heat dissipating portions each bendable into a substantially rectangular-section tube in accordance with the steps of claim 1.

4. The method of claim 3 further comprising repeating the three bending steps of claim 1 with respect to at least one unbent heat dissipating portion of the sheet to create at least one additional substantially rectangular-section tube.

5. The method or apparatus of claim 3, in which the plurality of heat dissipating portions are formed by at least one punching step.

6. The method or the apparatus of claim 3, in which the plurality of heat dissipating portions are formed by at least one cutting step.

7. The method of claim 1 or the apparatus of claim 2, in which the sheet of metal is comprised of an alloy having high thermal conductivity.

8. The method of claim 1 or the apparatus of claim 2, in which the sheet includes at least one opening for the passage of a device.

9. The method of claim 3 further comprising repeating the first bending step of claim 1 with respect to at least one unbent heat dissipating portion of the sheet to create a substantially planar surface that is substantially co-planar with the first substantially planar surface in the substantially rectangular-section tube.

10. The apparatus of claim 2 further comprising at least one additional substantially rectangular-section tube.

11. The apparatus of claim 11 in which at least one unbent heat dissipating portion of the sheet to create a substantially planar surface that is substantially co-planar with the first substantially planar surface in the substantially rectangular-section tube.

12. An apparatus for cooling heat-producing components, comprising:
a base; and
one or more substantially rectangular-section tubes having four walls, each one of the one or more rectangular-section tubes having the base as one of the four walls, the base and the one or more rectangular-section tubes being formed from a single sheet of metal.
